# EUROPEAN PATENT APPLICATION

(11) **EP 1 918 983 A1**
(43) Date of publication of application: **07.05.2008**
(21) Application number: 06782282.5
(22) Date of filing: 03.08.2006
(51) Int. Cl.: H01L 21/027, G03F 7/20, H01L 21/68

(54) **STAGE APPARATUS AND EXPOSURE APPARATUS**

(30) Priority: 05.08.2005 JP 2005227666
(71) Applicant: NIKON CORPORATION, Tokyo 100-8831 (JP)
(72) Inventor: SHIBAZAKI, Yuichi c/o NIKON CORPORATION, Chiyoda-ku, Tokyo 1008331 (JP)
(74) Representative: HOFFMANN EITLE
(86) International application number: PCT/JP2006/315422
(87) International publication number: WO 2007/018127

(57) **Abstract**

A wafer stage (WST) and a measurement stage (MST) are configured so that they are movable along an upper surface of a base plate (21), and water (Lq) is transferred therebetween by bringing the stages proximate to one another and moving them integrally in the Y directions. An alignment system (45) measures mutually proximate edge parts of the wafer stage (WST) and the measurement stage (MST), and a focus leveling detection system (64) measures a step in the Z directions in a state wherein the wafer stage (WST) and the measurement stage (MST) are proximate to one another. When both stages are brought proximate to one another, the relative position between the wafer stage (WST) and the measurement stage (MST) is adjusted based on the measurement results.

## Description

### TECHNICAL FIELD

The present invention relates to a stage apparatus that comprises a plurality of stages, as well as to an exposure apparatus.

Priority is claimed on Japanese Patent Application No. 2005-227666, filed on August 5, 2005, the contents of which are incorporated herein by reference.

### BACKGROUND ART

In a lithographic process, which is one of the processes used to fabricate a device such as a semiconductor device, a liquid crystal display device, an imaging device (for example, a charge coupled device, i.e., a CCD), or a thin film magnetic head, an exposure apparatus is used to transfer a pattern of a reticle, which serves as a mask, onto a wafer (or a glass plate and the like), which serves as a substrate and is coated with a photoresist, through a projection optical system. A full-field exposure type (stationary exposure type) projection exposure apparatus, such as a stepper, or a scanning exposure type projection exposure apparatus (scanning type exposure apparatus), such as a scanning stepper, can be used as the exposure apparatus.

In recent years, a liquid immersion type exposure apparatus has been realized wherein a space between the projection optical system and the wafer is filled with a liquid that has a refractive index that is higher than that of gas, thereby increasing the numerical aperture of the projection optical system and improving resolution. Patent Document 1 below discloses a technology that uses this type of exposure apparatus, wherein a plane parallel plate, which is set at a height position that is the same as that of the wafer, is provided, liquid is temporarily transferred between the projection optical system and the wafer onto the plane parallel plate when exchanging the wafer by moving the plane parallel plate to a position that is directly below the projection optical system while retracting the wafer from its position directly therebelow, and then, after the exchange is complete, a new wafer is disposed at the position that is directly below the projection optical system while retracting the plane parallel plate that is positioned directly therebelow, and thereby the space between the projection optical system and the new wafer is filled with a liquid.
[Patent Document 1]
   Japanese Patent Application, Publication No. 2005-19864 A

### DISCLOSURE OF INVENTION

### PROBLEMS TO BE SOLVED BY THE INVENTION

Incidentally, when liquid is transferred between two members, i.e., when liquid that is between the projection optical system and the wafer is transferred to the plane parallel plate temporarily, as disclosed in the abovementioned Patent Document 1, or when liquid that was transferred to the plane parallel plate is transferred back to the wafer, if a gap that is of a prescribed width or greater arises between those members, then there is a risk that the liquid will leak. In addition, if a step of a prescribed height or greater is created between those members, then there is a risk that the liquid will not be transferred completely and that some of it will remain. If liquid leaks, then it is conceivable that it will infiltrate the interior of the stage where it will cause rust or the like, which would degrade the performance of the substrate stage. In addition, there is also a risk that the heat of vaporization of the liquid will cause the temperature of the stage to fluctuate, which will lead to a decrease in exposure accuracy (for example, resolution, transfer fidelity, superpositional accuracy, and line width error).

It is an object of the present invention to provide a stage apparatus and an exposure apparatus that can transfer a liquid without any of that liquid leaking or remaining behind.

### MEANS FOR SOLVING THE PROBLEM

The present invention adopts the following configurations that correspond to the drawings, which describe the embodiments. However, any parenthesized symbol appended to an element is merely for the purpose of illustrating the element, and that element is not limited thereby.

A first aspect of the invention provides a stage apparatus that comprises: first and second stages (WST, MST) that move along a base surface (21a); a first measurement apparatus (64) that measures a first gap (G2) between the first and second stages along a first direction that intersects the base surface; and a first adjustment apparatus (20, 27, 47) that adjusts the first gap based on a measurement result of the first measurement apparatus.

According to this stage apparatus, the first measurement apparatus measures the relative position between the first stage and the second stage in the intersecting direction and, based on the measurement result, the first adjustment apparatus adjusts the relative position between the first stage and the second stage.

A second aspect of the invention provides a stage apparatus that comprises: first and second stages (WST, MST) that move along a base surface (21a); a measuring apparatus (22, 23) that measures the positions of the first and second stages along the base surface; a detection apparatus (45) that detects an edge of an upper surface of the first stage and an edge of an upper surface of the second stage; and an adjustment apparatus (20, 28a, 28b, 48a, 48b) that adjusts the position of at least one stage of the first and second stages along the base surface based on a measurement result of the measuring apparatus and a detection result of the detection apparatus.

According to this stage apparatus, the position detecting apparatus detects the positions of the first stage and the second stage in the first direction, the detection apparatus detects the edge part of the upper surface of the first stage and the edge part of the upper surface of the second stage, and, based on these detection results, the adjustment apparatus adjusts the position of at least one of the first stage and the second stage in the first direction.

A third aspect of the present invention provides an exposure apparatus, which exposes a substrate (W) through a liquid (Lq), that comprises: a stage apparatus according to the first aspect, wherein the first measurement apparatus measures the first gap without transiting through the liquid.

A fourth aspect of the present invention provides an exposure apparatus, which exposes a substrate (W) through a liquid (Lq), that comprises: a stage apparatus according to the second aspect, wherein the detection apparatus detects an edge of an upper surface of the first stage and detects an edge of the upper surface of the second stage without transiting through the liquid.

A fifth aspect of the present invention provides a device fabricating method that comprises an exposure process wherein the abovementioned exposure apparatus is used.

A sixth aspect of the present invention provides a method of moving an immersion area between a first member (WST) and a second member (MST), which are capable of relative movement, to perform immersion exposure that comprises: a first step that moves a liquid (Lq) between the first member and the second member; and a second step that, prior to the first step, measures the positional relationship between the first member and the second member.

A seventh aspect of the present invention provides an exposing method that exposes a substrate (W), which is held by a first member (WST), through a liquid (Lq), comprising: a first step that moves a liquid between the first member and a second member (MST), which is capable of moving relative to the first member; and a second step that, prior to the first step, measures the positional relationship between the first member and the second member.

An eighth aspect of the present invention provides a device fabricating method that comprises an exposure process, wherein the abovementioned exposing method is used.

A ninth aspect of the present invention provides an exposing method that is a method of fabricating an exposure apparatus (EX) that exposes a substrate (W) through a liquid (Lq), comprising: a step that supplies the abovementioned stage apparatus; and a step that measures the positional relationship between the first stage and the second stage without transiting through the liquid.

### EFFECTS OF THE INVENTION

The present invention measures the relative position between a first stage and a second stage and, based thereon, adjusts the relative position between the stages; thereby, it is possible to transfer a liquid between the first stage and the second stage without the liquid leaking or remaining behind.

### BRIEF DESCRIPTION OF THE DRAWINGS

FIG. 1 is a side schematic block diagram of an exposure apparatus according to one embodiment of the present invention.
FIG. 2 is an oblique view that shows the configuration of a stage apparatus.
FIG. 3 is a block diagram that shows the configuration of a control system of the exposure apparatus.
FIG. 4A shows the positional relationship between a wafer stage and a measurement stage when water is transferred.
FIG. 4B shows the positional relationship between the wafer stage and the measurement stage when water is transferred.
FIG. 5A is a view for explaining the measurement of the relative position between the wafer stage and the measurement stage in the Y directions using an alignment system.
FIG. 5B is a view for explaining the measurement of the relative position between the wafer stage and the measurement stage in the Y directions using the alignment system.
FIG 6A is a view for explaining the measurement of the relative position between the wafer stage and the measurement stage in the Y directions using the alignment system.
FIG. 6B is a view for explaining the measurement of the relative position between the wafer stage and the measurement stage in the Y directions using the alignment system.
FIG. 7A is a view for explaining the measurement of the relative position between the wafer stage and the measurement stage in the Z directions using a focus leveling detection system.
FIG. 7B is a view for explaining the measurement of the relative position between the wafer stage and the measurement stage in the Z directions using the focus leveling detection system.
FIG. 8 is a view for explaining the detection principle of a focus state detection system, which is provided to the alignment system.
FIG. 9A is an enlarged view of an edge part when the wafer stage and the measurement stage are in a proximate state.
FIG. 9B is an enlarged view of an edge part when the wafer stage and the measurement stage are in a proximate state.
FIG. 9C is an enlarged view of an edge part when the wafer stage and the measurement stage are in a proximate state.
FIG. 9D is an enlarged view of an edge part when the wafer stage and the measurement stage are in a proximate state.
FIG. 10 is a flow chart diagram that depicts one example of a process for fabricating a microdevice.

### DESCRIPTION OF THE REFERENCE SYMBOLS

20 : Main control apparatus, 21a : Moving surface, 22, 23 : Y axis interferometers, 27 : First drive system, 28a, 28b : Second drive systems, 45 : Alignment system, 47 : First drive system, 48a, 48b : Second drive systems, 64 : Focus leveling detection system, Lq : Water (liquid), MST : Mask stage, ST : Stage apparatus, W : Wafer (substrate), WST : Wafer stage.

### BEST MODE FOR CARRYING OUT THE INVENTION

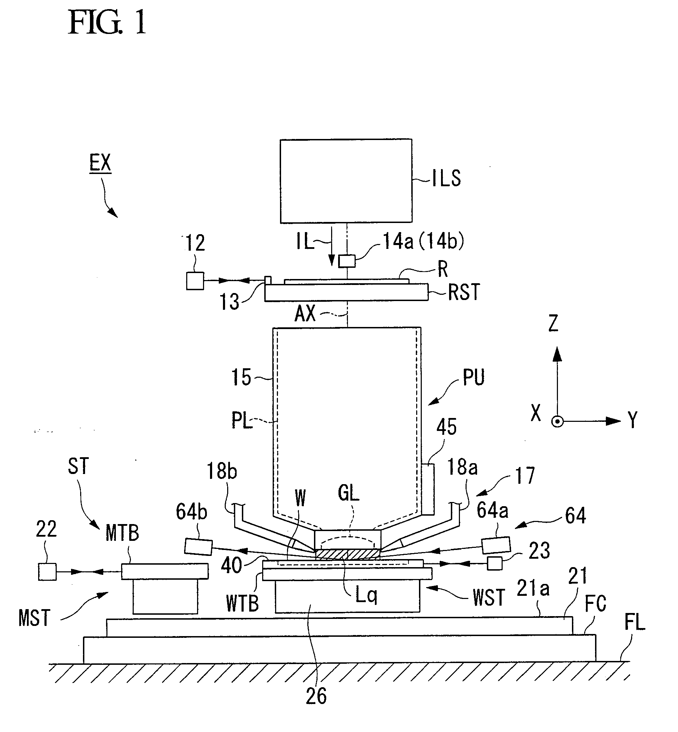

The following explains the details of a stage apparatus and an exposure apparatus according to one embodiment of the present invention, referencing the drawings. FIG 1 is a side schematic block diagram of the exposure apparatus according to one embodiment of the present invention. An exposure apparatus EX shown in FIG. 1 is a step-and-scan scanning exposure type exposure apparatus that transfers a pattern, which is formed in a reticle R, to multiple shot regions on a wafer W successively, while moving the reticle R, which serves as a mask, and the wafer W, which serves as a substrate, relative to a projection optical system PL shown in FIG. 1.

Furthermore, in the explanation below, an XYZ orthogonal coordinate system is defined in the figures and the positional relationships of members are described referencing this system as needed. The XYZ orthogonal coordinate system as shown in FIG. 1 is set so that the X axis and the Y axis are included in a plane that is parallel to a moving surface of the wafer W, and the Z axis is set in the directions along an optical axis AX of the projection optical system PL. In addition, in the present embodiment, the directions in which the reticle R and the wafer W are synchronously moved (the scanning directions) are set to the Y directions.

As shown in FIG 1, the exposure apparatus EX of the present embodiment comprises: an illumination optical system ILS; a reticle stage RST that holds the reticle R, which serves as the mask; a projection unit PU; a stage apparatus ST that further comprises a wafer stage WST, which serves as a first stage and holds the wafer W that serves as the substrate, and a measurement stage MST, which serves as a second stage; and a control system that controls these components. The illumination optical system ILS irradiates illumination light (exposure light) IL, which has substantially uniform luminous flux intensity, onto a slit shaped illumination area on the reticle R, which is defined by a reticle blind (not shown). Here, as one example, ArF excimer laser light (193 nm wavelength) is used as the illumination light IL.

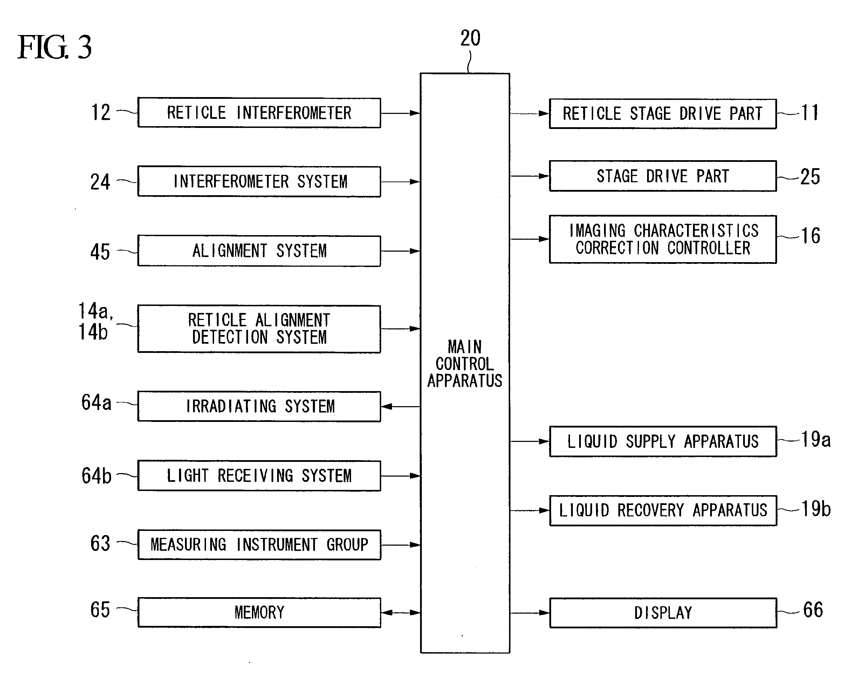

The reticle R, wherein a pattern is formed on its pattern surface (on the -Z side in FIG. 1), is held on the reticle stage RST by, for example, vacuum chucking. A reticle stage drive part 11 (not shown in FIG. 1, but refer to FIG. 3), which includes a linear motor or the like, can finely drive the reticle stage RST within the XY plane, which is perpendicular to the optical axis of the illumination optical system ILS (coincides with the optical axis AX of the projection optical system PL, which is discussed later), and can drive the reticle stage RST at a specified scanning speed in the scanning directions (the Y directions).

The position of the reticle stage RST within its plane of movement (including the rotation about the Z axis) is continuously detected by a laser interferometer (hereinafter, referred to as a reticle interferometer) 12 that has a resolving power of, for example, approximately 0.5-1 nm, via a movable mirror 13 (actually, a Y movable mirror that has a reflecting surface that is orthogonal to the Y axis and an X movable mirror that has a reflecting surface that is orthogonal to the X axis are provided). Measurement values of the reticle interferometer 12 are output to the main control apparatus 20 (not shown in FIG. 1, but refer to FIG. 3). The main control apparatus 20 calculates the position of the reticle stage RST in the X, Y, and θZ (the rotation around the Z axis) directions based on the measurement values of the reticle interferometer 12, and controls the position (and the velocity) of the reticle stage RST by controlling the reticle stage drive part 11 based on the calculation results.

Two reticle alignment detection systems 14a, 14b, each of which uses light of a wavelength that is the same as the exposure wavelength and comprises a through the reticle (TTR) alignment system, are provided above the reticle stage RST so that they are spaced apart by a prescribed distance in the X directions. The reticle alignment detection systems 14a, 14b simultaneously observe a pair of reticle alignment marks on the reticle R and conjugate images of a corresponding pair of fiducial marks on the measurement stage MST through the projection optical system PL. A system that is configured similarly to the one disclosed in, for example, Japanese Patent Application, Publication No. H7-176468 A (corresponding U.S. Patent No. 5,646,413) is used for both of the reticle alignment detection systems 14a, 14b.

The projection unit PU includes the projection optical system PL, which comprises a lens barrel 15 and multiple optical elements that are held therein with prescribed positional relationships. A dioptric system that comprises multiple lenses (lens elements), each of which has a common optical axis AX in the Z directions or the like, is used as the projection optical system PL. In addition, although not shown, an imaging characteristics correction controller 16 (refer to FIG. 3) controls a specified plurality of lenses of the plurality of lenses that constitute the projection optical system PL based on commands from the main control apparatus 20, which makes it possible to adjust the optical characteristics (including the imaging characteristics) of the projection optical system PL, e.g., magnification, distortion, coma aberration, and image plane curvature (including image plane inclination).

In addition, in order to perform an exposure wherein the exposure apparatus EX of the present embodiment adopts a liquid immersion method, a liquid supply nozzle 18a and a liquid recovery nozzle 18b of a liquid immersion apparatus 17 are provided in the vicinity of a lens (hereinbelow, also called a front lens) GL, which is the optical element that is closest to the image plane (the wafer W side) of the projection optical system PL. One end of a supply pipe (not shown) is connected to a liquid supply apparatus 19a (not shown in FIG. 1, but refer to FIG. 3) and its other end is connected to the liquid supply nozzle 18a. One end of a recovery pipe (not shown) is connected to a liquid recovery apparatus 19b (not shown in FIG. 1, but refer to FIG. 3) and its other end is connected to the liquid supply nozzle 18b.

Here, ultrapure water (unless otherwise required, hereinafter simply referred to as "water"), which transmits ArF excimer laser light (light of a 193 nm wavelength), is used as the abovementioned liquid. Ultrapure water is advantageous in that it can be obtained easily in large quantities at semiconductor fabrication plants and the like and does not adversely affect the optical lenses and the photoresist on, for example, the wafer W. Here, the refractive index *n* of water is substantially 1.44 and the wavelength of the illumination light IL in water is shortened to approximately 134 nm (193 nm × 1/*n*). In addition, an immersion area may be formed by supplying liquid of a temperature that is substantially the same as that of the wafer W. Thereby, it is possible to prevent, for example, thermal deformation of the wafer W that is caused by a temperature differential between the liquid and the wafer W.

In accordance with an instruction from the main control apparatus 20, the liquid supply apparatus 19a opens a valve that is connected to the supply pipe by a prescribed opening degree and supplies water through the liquid supply nozzle 18a to the space between the front lens GL and the wafer W. In addition, in accordance with an instruction from the main control apparatus 20, the liquid recovery apparatus 19b opens a valve that is connected to the recovery pipe by a prescribed opening degree and recovers the water from the space between the front lens GL and the wafer W through the liquid recovery nozzle 18b and stores it in the liquid recovery apparatus 19b (a tank of liquid). At this time, the main control apparatus 20 issues commands to the liquid supply apparatus 19a and the liquid recovery apparatus 19b so that the amount of water that is supplied through the liquid supply nozzle 18a and the amount of water that is recovered through the liquid recovery nozzle 18b to and from, respectively, the space between the front lens GL and the wafer W are always equal. Accordingly, a fixed amount of water Lq (refer to FIG. 1) is held between the front lens GL and the wafer W. Furthermore, the water Lq that is held between the front lens GL and the wafer W is replaced continuously.

As explained above, the liquid immersion apparatus 17 of the exposure apparatus according to the present embodiment is a local liquid immersion apparatus that comprises the liquid supply apparatus 19a, the liquid recovery apparatus 19b, the supply pipe, the recovery pipe, the liquid supply nozzle 18a, and the liquid recovery nozzle 18b.

The stage apparatus ST comprises: a frame caster FC, which is disposed, for example, on a floor surface FL of a semiconductor fab; a base plate 21, which is provided on the frame caster FC; the wafer stage WST and the measurement stage MST, which are disposed above the base plate 21 and move along an upper surface 21 a (a moving surface) thereof; an interferometer system 24 (refer to FIG. 3), which includes Y interferometers 22, 23 that detect the positions of the stages WST, MST; and a stage drive part 25 (refer to FIG 3) that drives the stages WST, MST. The abovementioned wafer stage WST holds and moves the wafer W in order to expose such by transferring the pattern of the reticle R thereto. Moreover, the measurement stage MST is positioned below the projection optical system PL-where it performs various measurements-during the interval of time when the wafer stage WST does not oppose the projection optical system PL, e.g., while the wafer stage WST is positioned at a loading position in order to exchange the wafer W. Furthermore, the liquid immersion apparatus 17 is capable of filling the water Lq between the front lens GL of the projection optical system PL and the wafer stage WST as well as between the front lens GL of the projection optical system PL and the measurement stage MST.

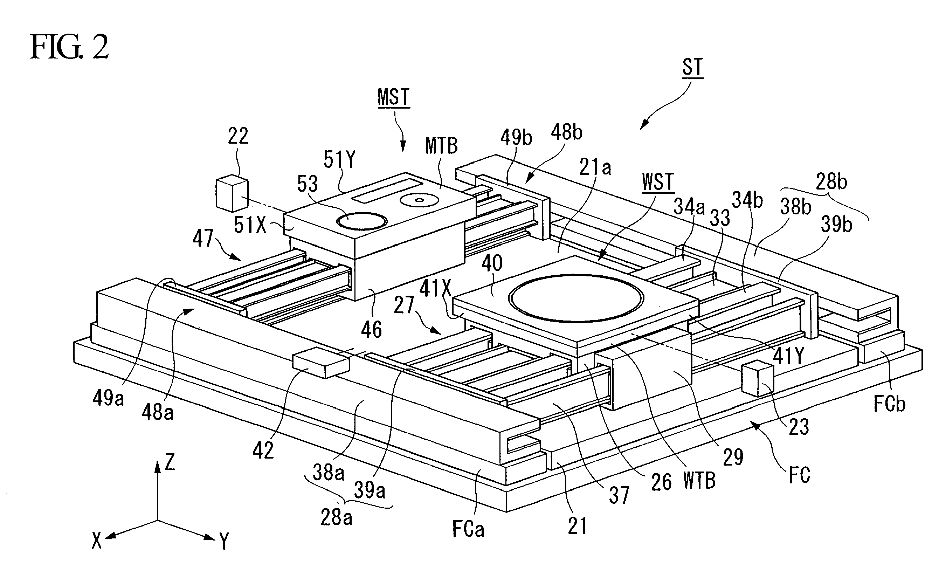

The following explains the details of the configuration of the stage apparatus ST. FIG. 2 is an oblique view that shows the configuration of the stage apparatus ST. As shown in FIG. 2, the substantially plate shaped frame caster FC comprises upwardly protruding parts FCa, FCb that are integrally formed in the vicinity of the end part on one side and the end part on the other side, respectively, of the frame caster FC in the X directions, and that are oriented so that the their longitudinal directions are in the Y directions. The base plate 21 is disposed on the frame caster FC in an area that is interposed by the protruding parts FCa, FCb of. The upper surface 21a (the moving surface) of the base plate 21 is finished with an extremely high degree of flatness and forms a guide surface when the wafer stage WST and the measurement stage MST move within the XY plane.

As shown in FIG. 2, the wafer stage WST comprises a wafer stage main body 26, which is disposed on the base plate 21, and a wafer table WTB, which is mounted on the wafer stage main body 26. The wafer stage main body 26 comprises a hollow member that has a rectangular frame shaped cross section and extends in the X directions. A self weight canceling mechanism, such as the one recited in Japanese Patent Application No. 2004-215434 (corresponding U.S. Patent No. 2006/009254) previously filed by the present applicant, is provided to the lower surface of the wafer stage main body 26. The self weight canceling mechanism comprises a support part, which supports the wafer stage WST by applying internal pressure to a bellows, and an air bearing part that opposes the moving surface 21 a, which serves as the guide surface, and levitates the wafer stage WST thereon.

In addition, the wafer stage WST comprises: a first drive system 27, which drives the wafer stage main body 26 with a long stroke in the X directions and also finely drives the wafer stage main body 26 in the Y, the Z, the θx (rotation around the X axis), the θy (rotation around the Y axis), and the θz (rotation around the Z axis) directions; and second drive systems 28a, 28b that drive the wafer stage main body 26 and the first drive system 27 with a long stroke in the Y directions. Furthermore, the wafer stage WST comprises a tube carrier 29, which moves in the X directions with uniform motion, and a pipe (not shown) that has six degrees of freedom and transmits the force of, for example, a vacuum or air, from the tube carrier 29 to the wafer stage main body 26. Here, the uniform motion of the tube carrier 29 in the X directions is for the purpose of reducing the impact of the reaction force that is generated by the drive thereof on the wafer stage main body 26.

Three openings are formed in the side surfaces of the wafer stage main body 26 on both the +X side and the -X side. A Y axis stator 33, which comprises a plurality of coils, is provided so that it passes through the wafer stage main body 26 through the substantially center opening of the three openings in each side surface. In addition, two X axis stators 34a, 34b are provided so that they pass through the wafer stage main body 26 through the two of the three openings, which are formed in each side surface, that sandwich, in the Y directions, the opening through which the Y axis stator 33 passes. Furthermore, a permanent magnet is provided to each of the three openings discussed above.

The abovementioned Y axis stator 33 cooperates with the permanent magnet that is provided to the opening through which the Y axis stator 33 passes and finely drives the wafer stage main body 26 in the Y directions. In addition, the abovementioned two X axis stators 34a, 34b cooperate with the permanent magnets, which are provided to the openings through which the X axis stators 34a, 34b pass, and drive the wafer stage main body 26 with a long stroke in the X directions. Here, it is possible to rotate the wafer stage main body 26 in the θz directions by creating a difference in the drive amounts of the X axis stators 34a, 34b.

Namely, the first drive system 27 comprises: a moving magnet type linear motor, which comprises the X axis stators 34a, 34b and permanent magnets; and a moving magnet type linear motor, which comprises the X axis stators 34a, 34b and permanent magnets. Furthermore, the above explained an exemplary case wherein moving magnet type linear motors are provided, but moving coil type linear motors may be provided. In addition, as described above, the wafer stage WST is a guideless stage that does not have a guide member that guides its movement in the X directions.

In addition, two Z axis stators (not shown), which extend in the X directions, and corresponding permanent magnets (not shown) are provided below the wafer stage main body 26. It is possible to drive the wafer stage main body 26 in the Z, the θx, and the θy directions by separately controlling the drive amount of each of the Z axis stators. In addition, a stator 37, which extends in the X directions, is provided in order to drive the tube carrier 29 in the X directions. Furthermore, both ends of the abovementioned Y axis stator 33, the X axis stator 34a, 34b, the Z axis stators, and the stator 37 are fixed to sliders 39a, 39b, which constitute the second drive systems 28a, 28b.

Y axis stators 38a, 38b, which extend in the Y directions and constitute the second drive systems 28a, 28b, are provided and disposed above the protruding parts FCa, FCb, respectively, of the frame castor FC. Aerostatic bearings (not shown), e.g., air bearings, that are provided to the lower surfaces of the Y axis stators 38a, 38b levitationally support these Y axis stators 38a, 38b above the protruding parts FCa, FCb, respectively, with a prescribed clearance. The reaction force that is generated by the movement of the wafer stage WST or the measurement stage MST in the Y directions moves the stators 38a, 38b, which serve as Y countermasses in the Y directions, in the reverse direction and is thereby offset by the law of conservation of momentum.

The wafer stage main body 26, which was discussed above, and the like are disposed between these stators 38a, 38b, and the sliders 39a, 39b, to which both ends of the Y axis stator 33, the X axis stator 34a, 34b, the Z axis stators, and the stator 37 are fixed, are inserted in the stators 38a, 38b, respectively, from their inner sides. The stators 38a, 38b comprise permanent magnets, which are arrayed in the Y directions, and the sliders 39a, 39b comprise coils, which are arrayed in the Y directions. Namely, the second drive systems 28a, 28b comprise moving coil type linear motors that drive the wafer stage WST in the Y directions. Furthermore, the above explained an exemplary case wherein moving coil type linear motors are provided, but moving magnet type linear motors may be provided.

With the exception of the electromagnetic coupling between the stator 38a and the slider 39a and between the stator 38b and the slider 39b, the wafer stage WST is a guideless stage that does not have a guide member that guides its movement in the Y directions. Furthermore, the reaction force that is generated when the wafer stage WST moves in the X directions is transmitted to X countermasses (not shown) through the electromagnetic coupling between the stator 38a and the slider 39a and between the stator 38b and the slider 39b, which are provided to the second drive systems 28a, 28b. These X countermasses are provided between the stator 38a and the protruding part FCa of the frame castor FC and between the stator 38b and the protruding part FCb of the frame castor FC, and are configured so that they hold the stators 38a, 38b, which are used as countermasses in the Y directions, and are movable in the X directions. The X countermasses move in a direction that is the reverse of that of the X directional movement of the wafer stage WST and/or the measurement stage MST, and thereby offsets the reaction force that is generated when the wafer stage WST is driven in the X directions. Furthermore, with the stage apparatus ST of the present embodiment, the X countermasses and the Y countermasses are shared by the wafer stage WST and the measurement stage MST, but just the X countermasses or just the Y countermasses may be shared by the wafer stage WST and the measurement stage MST.

A wafer holder 40, which holds the wafer W, is provided on the wafer table WTB. The wafer holder 40 comprises a plate shaped main body part and a liquid repellent (water repellent) auxiliary plate, wherein a circular aperture (the diameter of which is larger than that of the wafer W) is formed at its center, that is fixed to the upper surface of the main body part. Numerous (a plurality of) pins are disposed in an area of the main body part inside the circular opening of the auxiliary plate. The numerous pins vacuum chuck the wafer W in a supported state. In this state, wherein the wafer W is vacuum chucked, the height of the front surface of the wafer W and that of the front surface of the auxiliary plate are substantially the same. Furthermore, liquid repellency may be imparted to the front surface of the wafer table WTB without providing the auxiliary plate.

In addition, as shown in FIG. 2, a reflecting surface 41X, which is orthogonal to the X directions (i.e., extends in the Y directions) is formed by mirror polishing at one end (the +X side end) of the wafer table WTB in the X directions. Likewise, a reflecting surface 41Y, which is orthogonal to the Y directions (i.e., extends in the X directions) is formed by mirror polishing at one end (the +Y side end) of the wafer table WTB in the Y directions. Interferometer beams (beams) from the X axis interferometer 42 and the Y axis interferometer 23, which constitute the interferometer system 24 (refer to FIG. 3), are projected to the reflecting surfaces 41X, 41Y.

The X axis interferometer 42 and the Y axis interferometer 23 receive the light reflected from the reflecting surfaces 41X, 41Y, respectively, and thereby detect the displacements of the reflecting surfaces 41X, 41Y in the measurement directions from reference positions (generally, fixed mirrors are disposed on the side surfaces of the projection unit PU and/or the side surfaces of an off-axis type alignment system 45, which is disposed on the +Y direction side of the projection optical system PL-refer to FIG. 1 and FIG. 3-and are used as the reference surfaces). Furthermore, instead of the configuration wherein the reflecting surfaces 41 X, 41 Y are formed on the end surfaces of the wafer table WTB, a configuration is also acceptable wherein a Y movable mirror that has the reflecting surface (41Y) that extends in the X directions and an X movable mirror that has the reflecting surface (41X) that extends in the Y directions are provided on the upper surface of the wafer table WTB.

The X axis interferometer 42 has a length measuring axis that passes through the center of projection of the projection optical system PL (the optical axis AX; refer to FIG. 1) and is parallel to the X axis, and a length measuring axis that passes through a center of the measurement field of the alignment system 45 and is parallel to the X axis. The X axis interferometer 42 detects the position of the wafer table WTB in the X directions on the length measuring axis that passes through the projection center position of the projection optical system PL when an exposure is performed, and measures the position of the wafer table WTB in the X directions on the length measuring axis that passes through the measurement field center of the alignment system 45 when enhanced global alignment (EGA) is performed. In addition, the X axis interferometer 42 measures the position of the measurement table MTB in the X directions by appropriately using two length measuring axes in accordance with the measurement of the baseline quantity and/or the measurement details of various measuring instruments that are provided to the measurement stage MST.

In other words, the X axis interferometer 42 is capable of measuring the position of the wafer table WTB or the measurement table MTB in the X directions at the projection center position and the alignment center position in the Y directions. Furthermore, the baseline quantity is a quantity that indicates the positional relationship of the wafer stage WST with respect to the projected image of the pattern that is projected by the projection optical system PL; specifically, it is the distance between the center of projection of the projection optical system PL and the center of the measurement field of the alignment system 45. The Y axis interferometer 23 has a length measuring axis that is parallel to the Y axis and that connects the center of projection of the projection optical system PL (the optical axis AX; refer to FIG. 1) and the center of the measurement field of the alignment system 45, and principally detects the position of the wafer table WTB in the Y directions.

With the exceptions of the tube carrier 29 and the pipe (not shown) that has six degrees of freedom, the measurement stage MST has a configuration that is substantially similar to that of the wafer stage WST. Namely, as shown in FIG. 2, the measurement stage MST comprises a measurement stage main body 46, which is disposed on the base plate 21, and the measurement table MTB, which is mounted on the measurement stage main body 46. In addition, the measurement stage MST comprises: a first drive system 47, which drives the measurement stage main body 46 with a long stroke in the X directions and finely drives it in the Y, the Z, the θx, the θy, and the θz directions; and second drive systems 48a, 48b, which drive the measurement stage main body 46 and the first drive system 47 with a long stroke in the Y directions. The measurement stage main body 46 comprises a hollow member that has a rectangular frame shaped cross section and extends in the X directions.

Similar to the first drive system 27 that is provided to the wafer stage WST, the first drive system 47 comprises: pairs of permanent magnets, which are disposed in each of the three openings provided to the end surfaces of the measurement stage main body 46 in the +X and -X directions, and one Y axis stator and two X axis stators, which each comprise a plurality of coils so that they pass through the measurement stage main body 46 in the X directions through each of the openings. The permanent magnets along with the X axis stators and the Y axis stator drive the measurement stage main body 46 with a long stroke in the X directions, finely drive it in the Y directions, and rotate it in the θz directions. In addition, the first drive system 47 comprises permanent magnets, which are provided to the lower surface of the measurement stage main body 46, and Z axis stators, which cooperate with the permanent magnets and generate thrust. These permanent magnets and Z axis stators can drive the measurement stage main body 46 in the Z directions, the θx, and the θy directions. Furthermore, the above explained an exemplary case wherein the first drive system 47 comprises moving magnet type linear motors, but it may comprise moving coil type linear motors.

The second drive systems 48a, 48b comprise the stators 38a, 38b and sliders 49a, 49b that are fixed to both ends of the X axis stators that pass through the measurement stage main body 46 in the X directions, the Y axis stators, and Z axis stators that are disposed below (in the -Z direction of) the measurement stage main body 46; in addition, the sliders 49a, 49b are inserted in the stators 38a, 38b from their inner sides. The sliders 49a, 49b comprise coils, which are arrayed in the Y directions, and cooperate with the stators 38a, 38b, which comprise the permanent magnets that are arrayed in the Y directions, to generate thrust in the Y directions. Namely, the second drive systems 48a, 48b comprise moving coil type linear motors that drive the measurement stage MST in the Y directions. Thus, in the present embodiment, the stators 38a, 38b are configured so that the linear motors (the actuator parts) that drive the wafer stage WST in the Y directions and the linear motors (the actuator parts) that drive the measurement stage MST in the Y directions are shared. Furthermore, the above explained an exemplary case wherein moving coil type linear motors are provided, but moving magnet type linear motors may be provided.

At least part of the stage drive part 25 shown in FIG. 3 comprises, as explained above, the first drive system 27 and the second drive systems 28a, 28b, which drive the wafer stage WST, and the first drive system 47 and the second drive systems 48a, 48b, which drive the measurement stage MST. A main control apparatus 20 shown in FIG. 3 controls the various drive mechanisms that constitute the stage drive part 25. In other words, the main control apparatus 20 controls via the stage drive part 25, for example, the movement of the measurement stage MST prior to the exposure of the wafer W and the movement of the wafer stage WST after the wafer W is exposed.

The measurement table MTB is formed from, for example, a low thermal expansion material, such as Zerodur^{®} made by Schott Nippon K.K., and its upper surface is liquid repellent (water repellent). The measurement table MTB is held on the measurement stage main body 46 by, for example, vacuum chucking, and is configured so that it is exchangeable. The height of the front surface of the measurement table MTB is set so that it is substantially identical to that of the front surface of the wafer holder 40, which is provided on the wafer table WTB. A reflecting surface 51X that is orthogonal to the X directions (i.e., extends in the Y directions) is formed by mirror polishing at one end (the +X side end) of the measurement table MTB in the X directions. Likewise, a reflecting surface 51Y, which is orthogonal to the Y directions (i.e., extends in the X directions) is formed by mirror polishing at one end (the -Y side end) of the measurement table MTB in the Y directions.

Interferometer beams (beams) from the X axis interferometer 42 and the Y axis interferometer 22, which constitute the interferometer system 24 (refer to FIG. 3), are projected to the reflecting surfaces 51X, 51Y. The X axis interferometer 42 and the Y axis interferometer 22 receive the reflected beams from the reflecting surfaces 51X, 51 Y, respectively, and thereby detect the displacements in the measurement directions of the reflecting surfaces 51X, 51Y from reference positions (generally, fixed mirrors are disposed on side surfaces of the projection unit PU and/or side the surfaces of an off axis alignment system 45-refer to FIG. 1 and FIG. 3-and are used as reference surfaces).

Furthermore, instead of the configuration wherein the reflecting surfaces 51X, 51Y are formed on the end surfaces of the measurement table MTB, a configuration is also acceptable wherein a Y movable mirror that has a reflecting surface (51 Y) that extends in the X directions and an X movable mirror that has a reflecting surface (51X) that extends in the Y directions are provided to the upper surface of the measurement table MTB. Similar to the Y axis interferometer 23, the abovementioned Y axis interferometer 22 has a length measuring axis that is parallel to the Y axis and that connects the center of projection (the optical axis AX; refer to FIG. 1) of the projection optical system PL and the center of the measurement field of the alignment system 45. Excluding the time during which the wafer stage WST is positioned at the loading position (not shown) in order to exchange the wafer W, the Y axis interferometer 22 detects the position of the measurement table MTB in the Y directions.

In addition, the measurement stage MST further comprises a measuring instrument group for performing various measurements related to the exposure. Examples of measuring instruments in the measuring instrument group include an aerial image measuring apparatus, a wavefront aberration measuring apparatus, and an exposure detection apparatus. The aerial image measuring apparatus measures an aerial image that is projected onto the measurement table MTB through the projection optical system PL and the water. In addition, the wavefront aberration measuring apparatus disclosed in, for example, PCT International Publication WO 99/60361 (corresponding European Patent No. 1,079,223) can be used as the abovementioned wavefront aberration measuring apparatus.

In addition, the exposure detection apparatus is a detection apparatus that acquires information (for example, the amount of light, the luminous flux intensity, and the luminous flux intensity nonuniformity) that is related to the exposure energy of the exposure light that is irradiated onto the measurement table MTB through the projection optical system PL, and it is possible to use a luminous flux intensity nonuniformity measuring instrument as disclosed in, for example, Japanese Patent Application, Publication No. S57-117238 A (corresponding U.S. Patent No. 4,465,368) or a luminous flux intensity monitor as disclosed in, for example, Japanese Patent Application, Publication No. H11-16816 A (corresponding U.S. Patent Application, Publication No. 2002/0061469) as the exposure detection apparatus. Furthermore, in FIG. 3, the aerial image measuring apparatus, the wavefront aberration measuring apparatus, and the exposure detection apparatus that were explained above are shown as a measuring instrument group 63.

A fiducial plate 53, which serves as a measurement pattern part wherein various marks are formed that are used by the measuring instrument group or the alignment system 45 (refer to FIG. 1 and FIG. 3), is provided at a prescribed position on the upper surface of the measurement table MTB. This fiducial plate 53 is formed from a low thermal expansion material, its upper surface is liquid repellent (water repellent), and it is configured so that it is exchangeable, i.e., an existing one can be removed from the measurement table MTB and a new one disposed thereon.

Returning to FIG. 1, the off-axis type alignment system 45, which is provided to a holding member that holds the projection unit PU, measures the position of a target mark (for example, an alignment mark formed on the wafer W or a fiducial mark formed on the fiducial plate 53). This alignment system 45 is an alignment sensor of an image processing type field image alignment (FIA) system that: irradiates a target mark with a broadband detection light beam that does not photosensitize the resist on, for example, the wafer W; uses an imaging device (for example, CCD) to capture an image of an index (an index pattern on an index plate provided on the alignment system 45), which is not shown, and an image of a target mark that is imaged on a light receiving surface by the light reflected from that target mark; and outputs imaging signals thereof. The imaging signals from the alignment system 45 are supplied to the main control apparatus 20 shown in FIG. 3.

Furthermore, returning to FIG. 1 and FIG. 3, the exposure apparatus EX of the present embodiment comprises a focus leveling detection system 64, which comprises an irradiating system 64a and a light receiving system 64b. The focus leveling detection system 64 is as disclosed in, for example, Japanese Patent Application, Publication No. 2004-207710, and detects the position in the Z directions and the attitude (rotation around the X and Y axes) of the wafer W by irradiating each detection point of a plurality of detection points set inside an exposure area (a projection area of the projection optical system PL) with sensor light from the irradiating system 64a from a diagonal direction, and receiving the reflected light thereof with the light receiving system 64b. The detection result of the focus leveling detection sensor 64 is output to the main control apparatus 20. The main control apparatus 20 drives the stage drive part 25 based on the detection results of the focus leveling detection system 64 so as to adjust the position (the focus position) in the Z directions and the attitude of the wafer W, which is held on the wafer stage WST, and thereby optimally aligns the front surface of the wafer W with the image plane of the projection optical system PL using the autofocus system and the auto leveling system.

FIG. 3 is a block diagram that shows the configuration of a control system of the exposure apparatus EX. The control system shown in FIG. 3 comprises the main control apparatus 20, which is the core of the control system and comprises a microcomputer (or a workstation) that provides supervisory control of the entire operation of the exposure apparatus EX. In addition, memory 65 and a display 66, such as a cathode ray tube (CRT) display or a liquid crystal display, are connected to the main control apparatus 20. The memory 65 stores the information that is needed to control the operation of the exposure apparatus EX, e.g., the baseline quantity, the shot layout obtained by performing EGA calculation, and a record of the exposure amounts. The display 66 displays a variety of information, such as error information and information that indicates the apparatus state of the exposure apparatus EX, that is output from the main control apparatus 20.

The operation of the exposure apparatus EX as configured above will now be explained. In the exposure apparatus EX of the present embodiment, the wafer W is exposed in a state wherein the main control apparatus 20 controls the switching of the valves of both the liquid supply apparatus 19a and the liquid recovery apparatus 19b of the liquid immersion apparatus 17 so as to fill the space directly below the front lens GL of the projection optical system PL with the water Lq. When the exposure of the wafer W that is held on the wafer stage WST is complete, the wafer stage WST moves to the loading position in order to exchange the wafer W, and the measurement stage MST moves to a position below (in the -Z direction of) the projection optical system PL in order to perform various measurements.

At this time, the measurement stage MST approaches the wafer stage WST and both stages move integrally, and thereby the water Lq that is directly below the front lens GL of the projection optical system PL is transferred to the measurement stage MST. When the transfer of the water Lq is complete, the wafer stage WST moves to the loading position and exchanges the wafer W, and the measurement stage MST remains below the projection optical system PL and performs various measurements.

When the exchange and the measurement of the wafer W are complete, the measurement stage MST moves to a prescribed retraction position, and the wafer stage WST moves to a position that is below (in the -Z direction of) the projection optical system PL. At this time, the wafer stage WST approaches the measurement stage MST, and both stages move integrally once again; thereby, the water Lq that is directly below the front lens GL of the projection optical system PL is transferred from the measurement stage MST to the wafer stage WST.

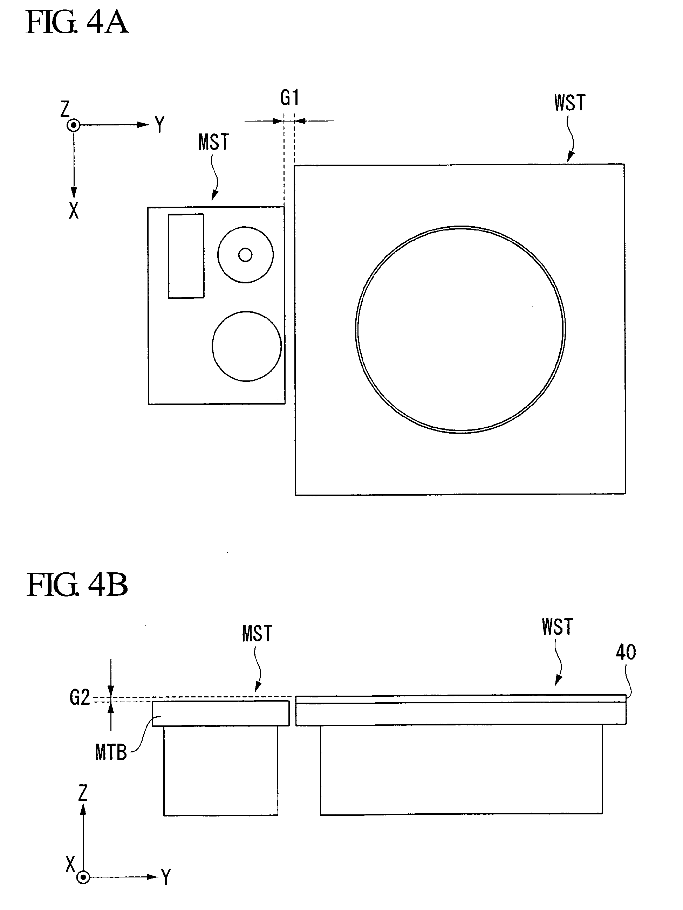

FIG. 4A is a top view that shows the positional relationship between the wafer stage WST and the measurement stage MST when the water Lq is transferred, and FIG. 4B is a side view thereof. When the wafer stage WST and the measurement stage MST are brought into contact with one another during the transfer of the water Lq, there is a risk that mechanical damage will occur or that errors in the positions of the stages will occur. Consequently, as shown in FIG. 4A, when the water Lq is transferred, each stage is controlled so that a small gap G1 is maintained between the wafer stage WST and the measurement stage MST. This gap G1 is maintained at, for example, less or equal to 0.5 mm (preferably approximately 0.2 mm) so that the water Lq does not leak.

In addition, if a step (a gap G2) is created between the upper surface of the wafer stage WST (the front surface of the wafer holder 40) and the upper surface of the measurement stage MST (the front surface of the measurement table MTB) when the water Lq is transferred, then there is a risk that the water Lq will not be completely transferred and will remain on the original stage. Consequently, the gap G2 between the upper surfaces of both stages is controlled so that the water Lq does not remain. The gap G2 is set to, for example, less or equal to 0.1 mm.

The main control apparatus 20 controls the wafer stage WST and the measurement stage MST so that the gap G1 is, for example, less or equal to 0.5 mm, and the gap G2 is, for example, less or equal to 0.1 mm during the transfer of the water Lq. Nevertheless, a case is conceivable wherein, because of, for example, the accumulation of positional errors of each of the stages, the gap G1 cannot be maintained at less or equal to 0.5 mm or the gap G2 cannot be maintained at less or equal to 0.1 mm. In addition, if the wafer stage WST or the measurement stage MST rotate around the Z axis during the transfer of the water Lq, then it is conceivable that the gap G1 between the wafer stage WST and the measurement stage MST will change positionally.

Consequently, in the present embodiment, the alignment system 45 and the focus leveling detection system 64 are used to measure the relative position between the wafer stage WST and the measurement stage MST when the exposure apparatus EX starts up, during periodic maintenance, or when a reset is performed that sets the apparatus state of the exposure apparatus EX to its initial state in the event of a power outage or an error. Furthermore, during the measurement of the relative position, the valves of both the liquid supply apparatus 19a and the liquid recovery apparatus 19b are in a closed state, and therefore the water Lq is not supplied to the space directly below the front lens GL of the projection optical system PL.

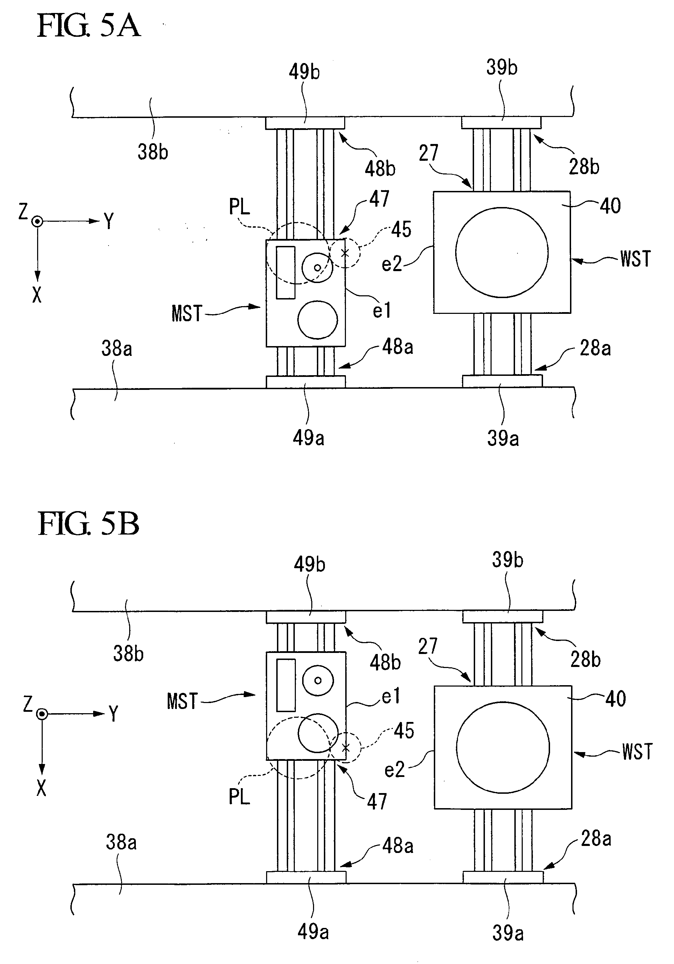

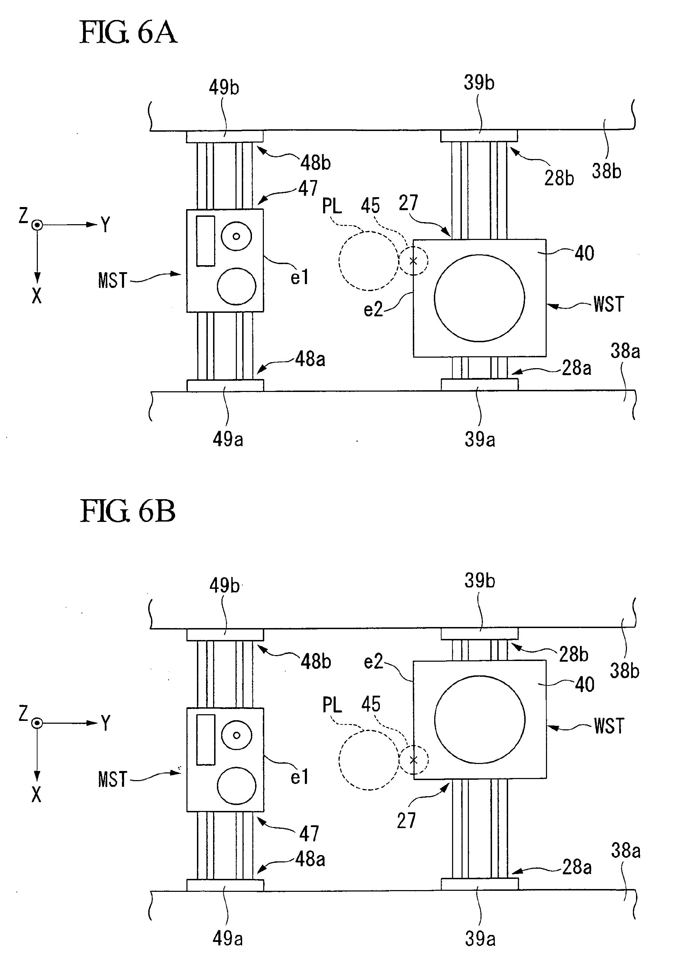

FIGS. 5A, 5B, 6A, and 6B are views for explaining the measurement of the relative position between the wafer stage WST and the measurement stage MST in the Y directions using the alignment system 45. When the measurement process begins, the main control apparatus 20 monitors the detection values of the Y axis interferometers 22, 23 shown in FIG. 1 and FIG. 2, and, while doing so, drives the second drive systems 28a, 28b, which are provided to the wafer stage WST, so as to retract the wafer stage WST to the loading position, and drives the second drive systems 48a, 48b, which are provided to the measurement stage MST, so as to dispose the measurement stage MST below (in the -Z direction of) the projection optical system PL.

At this time, the measurement stage MST is moved so that an edge part e1 of the measurement table MTB on the +Y direction side enters a measurement field of the alignment system 45. Next, the main control apparatus 20 drives the first drive system 47, which is provided to the measurement stage MST, so as to move the measurement stage MST in the +X direction, and, as shown in FIG. 5A, disposes the measurement stage MST so that an end part (hereinbelow, called a measurement point P11) of the edge part e1 in the -X direction enters the measurement field of the alignment system 45. In this state, the measurement point P11 is imaged using the alignment system 45. The imaging signal is supplied to the main control apparatus 20 and is stored together with the result of the detection by the Y axis interferometer 22 at the point in time when the measurement point P11 was imaged.

Subsequently, the main control apparatus 20 drives the first drive system 47, which is provided to the measurement stage MST, so as to move the measurement stage MST in the -X direction, and, as shown in FIG. 5B, disposes the measurement stage MST so that an end part (hereinbelow, called a measurement point P12) of the edge part e1 in the +X direction enters the measurement field of the alignment system 45. In this state, the measurement point P12 is imaged using the alignment system 45. The imaging signal is supplied to the main control apparatus 20 and stored together with the result of the detection by the Y axis interferometer 22 at the point in time when the measurement point P12 was imaged. The main control apparatus 20 derives position information about the measurement points P11, P 12 in the measurement field by image processing each of the imaging signals of the measurement points P11, P12 obtained by the above process, and, based on this position information and the result of the detection by the Y axis interferometer 22 that was obtained at the point in time when the imaging signals were acquired, derives position information about the measurement points P11, P12 in the Y directions.

Next, the main control apparatus 20 monitors the detection values of the Y axis interferometers 22, 23 shown in FIG. 1 and FIG. 2, and, while doing so, drives the second drive systems 48a, 48b, which are provided to the measurement stage MST, so as to retract the measurement stage MST to the prescribed retraction position, and drives the second drive systems 28a, 28b, which are provided to the wafer stage WST, so as to dispose the wafer stage WST below (in the -Z direction of) the projection optical system PL. At this time, the wafer stage WST is moved so that an edge part e2 of the wafer holder 40 on the -Y direction side enters the measurement field of the alignment system 45.

When the movement is complete, the main control apparatus 20 drives the first drive system 27, which is provided to the wafer stage WST, so as to move the wafer stage WST in the +X direction, and, as shown in FIG. 6A, disposes the wafer stage WST so that an end part (hereinbelow, called a measurement point P21) of the edge part e2 in the -X direction enters the measurement field of the alignment system 45. In this state, the measurement point P21 is imaged using the alignment system 45. The imaging signal is supplied to the main control apparatus 20 and is stored together with the result of the detection by the Y axis interferometer 23 at the point in time when the measurement point P21 was imaged.

Subsequently, the main control apparatus 20 drives the first drive system 27, which is provided to the wafer stage WST, so as to move the wafer stage WST in the -X direction, and, as shown in FIG. 6B, disposes the wafer stage WST so that an end part (hereinbelow, called a measurement point P22) of the edge part e2 in the +X direction enters the measurement field of the alignment system 45. In this state, the measurement point P22 is imaged using the alignment system 45. The imaging signal is supplied to the main control apparatus 20 and stored together with the result of the detection by the Y axis interferometer 23 at the point in time when the measurement point P22 was imaged.

The main control apparatus 20 derives position information about the measurement points P21, P22 in the measurement field by image processing each of the imaging signals of the measurement points P21, P22 that were obtained by the above process, and, based on this position information and the result of the detection by the Y axis interferometer 23 that was obtained at the point in time when the imaging signals were acquired, derives position information about the measurement points P21, P22 in the Y directions.

The relative positional relationship between the edge part e1 and the edge part e2 in the Y directions, i.e., the relative position between the wafer stage WST and the measurement stage MST in the Y directions, is derived based on position information about the measurement points P11, P12 and position information about the measurement points P21, P22 obtained from the above process. Because the edge part e1 is measured at the plurality of measurement points P 11, P 12 and the edge part e2 is measured at the plurality of measurement points P21, P22, it is also possible to derive the amount of deviation from parallelism of the edge part e1 and the edge part e2 that is caused by the rotation of the wafer stage WST or the measurement stage MST around the Z axis. Furthermore, information that indicates the relative position between the wafer stage WST and the measurement stage MST in the Y directions that was obtained by the above process is stored in the memory 65 (refer to FIG. 3) and is used in controlling the wafer stage WST and the measurement stage MST during exposure.

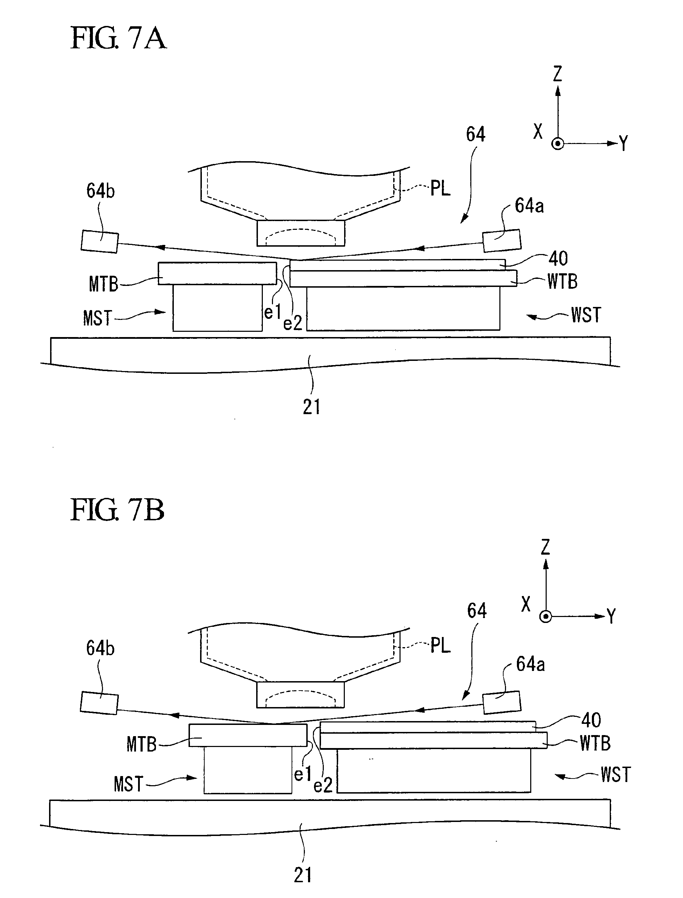

FIG. 7A and 7B are views for explaining the measurement of the relative position between the wafer stage WST and the measurement stage MST in the Z directions using the focus leveling detection system 64. When the measurement process begins, the main control apparatus 20 monitors the detection values of the Y axis interferometers 22, 23 shown in FIG. 1 and FIG. 2, and, while doing so, drives the second drive system 28a, 28b, which are provided to the wafer stage WST, so as to dispose the wafer stage WST and the measurement stage MST so that they are positioned below (in the -Z direction of) the projection optical system PL in a state wherein the edge parts e1, e2 are in close proximity to one another.

At this time, as shown in FIG. 7A, the wafer stage WST and the measurement stage MST are set to a position in the Y directions such that a detection area of the focus leveling detection system 64 is set so that it is on the wafer holder 40 in the vicinity of the edge part e2. When the disposing in the Y directions is complete, the main control apparatus 20 drives the first drive system 27, which is provided to the wafer stage WST, so as to move the wafer stage WST in the +X direction, and disposes the wafer stage WST so that the detection area of the focus leveling detection system 64 is set on the wafer holder 40 in the vicinity of an end part of the edge part e2 in the -X direction (hereinbelow, called a measurement surface P31). In this state, the measurement surface P31 is detected using the focus leveling detection system 64. The detection result is supplied to the main control apparatus 20.

Subsequently, the main control apparatus 20 drives the first drive system 27, which is provided to the wafer stage WST, so as to move the wafer stage WST in the -X direction, and disposes the wafer stage WST so that the detection area of the focus leveling detection system 64 is set so that it is on the wafer holder 40 in the vicinity of an end part of the edge part e2 in the +X direction (hereinbelow, called a measurement surface P32). In this state, the measurement surface P32 is detected using the focus leveling detection system 64. The detection result is supplied to the main control apparatus 20.

Next, the main control apparatus 20 monitors the detection values of the Y axis interferometers 22, 23 shown in FIG. 1 and FIG. 2, and, while doing so, drives the second drive systems 48a, 48b, which are provided to the measurement stage MST, and the second drive systems 28a, 28b, which are provided to the wafer stage WST, so as to move the wafer stage WST and the measurement stage MST in the +Y direction while preserving their positional relationship. At this time, as shown in FIG. 7B, the wafer stage WST and the measurement stage MST are set to a position in the Y directions so that the detection area of the focus leveling detection system 64 is set on the measurement table MTB in the vicinity of the edge part e1.

When the disposing in the Y directions is complete, the main control apparatus 20 drives the first drive system 47, which is provided to the measurement stage MST, so as to move the measurement stage MST in the +X direction, and disposes the measurement stage MST so that the detection area of the focus leveling detection system 64 is set on the measurement table MTB in the vicinity of an end part of the edge part e1 in the -X direction (hereinbelow, called a measurement surface P41). In this state, the measurement surface P41 is detected using the focus leveling detection system 64. The detection result is supplied to the main control apparatus 20.

Subsequently, the main control apparatus 20 drives the first drive system 47, which is provided to the measurement stage MST, so as to move the measurement stage MST in the -X direction, and disposes the measurement stage MST so that the detection area of the focus leveling detection system 64 is set so that it is on the measurement table MTB in the vicinity of an end part of the edge part e1 in the +X direction (hereinbelow, called a measurement surface P42). In this state, the measurement surface P42 is detected using the focus leveling detection system 64. The detection result is supplied to the main control apparatus 20.

The relative positional relationship between the wafer holder 40 and the measurement table MTB in the Z directions, i.e., the relative position between the wafer stage WST and the measurement stage MST in the Z directions, is derived based on the results of the detection of the measurement surfaces P31, P32 and of the measurement surfaces P41, P42 obtained from the above process. Furthermore, information obtained from the above process that indicates the relative position between the wafer stage WST and the measurement stage MST in the Z directions is stored in the memory 65 (refer to FIG. 3) and is used in controlling the wafer stage WST and the measurement stage MST during exposure.

When the exposure apparatus EX starts up, when periodic maintenance is performed, or when a reset is performed, the process of exposing the wafer W is started after the measurement process explained above is complete. Next, the details of the exposure process will be explained. When a wafer W is exposed, the measurement stage MST is disposed at the prescribed retraction position, and the wafer stage WST, which holds the wafer W to be exposed, is disposed below (in the -Z direction of) the projection optical system PL.

Furthermore, in a state wherein there is no water Lq on the wafer W before the water Lq is supplied from the liquid supply apparatus 19a, a process of measuring an alignment mark that is formed on the wafer W is performed. Furthermore, it is assumed herein that the pattern of at least one layer is formed on the wafer W; however, if no layer pattern is formed on the wafer W at all, then the process of measuring an alignment mark is omitted.

In the measurement process, the main control apparatus 20 monitors the detection results of the X axis interferometer 42 and of the Y axis interferometer 23, and, while doing so, drives the first drive system 27 and the second drive systems 28a, 28b, which are provided to the wafer stage WST, so as to move the wafer stage WST along a prescribed pathway. Along the way of this movement, the alignment system 45 is used to measure a plurality of alignment marks formed on the wafer W without transiting through the water Lq. Furthermore, when the alignment mark is measured by the alignment system 45, the wafer stage WST is in a stopped state.

Thereby, the position of each alignment mark is measured within a coordinate system that is defined by the X axis interferometer 42 and the Y axis interferometer 23. Furthermore, when the alignment system 45 measures the alignment marks on the wafer W, it may measure all of the alignment marks, or only a portion thereof. In addition, if the alignment system 45 can measure the alignment mark on the wafer W while the wafer W is moved, then the wafer stage WST does not need to be set to the stopped state.

In addition, during the abovementioned movement of the wafer stage WST, front surface information about the wafer W is detected by the focus leveling detection system 64 without transiting through the water Lq. The focus leveling detection system 64 detects surface information for each shot region (not shown) that is set on the wafer W, and stores the detection results in the main control apparatus 20 associated with the position on the wafer W in the scanning directions (the Y axial directions). Furthermore, the focus leveling detection system 64 may detect the surface information of just a portion of the shot regions. In addition, either the operation of measuring position information of the plurality of alignment marks using the alignment system 45 or the operation of detecting surface information about the wafer W using the focus leveling detection system 64 may be completed before the other, and subsequently the other operation may be performed.

When the abovementioned measurements are complete, the main control apparatus 20 performs enhanced global alignment (EGA) calculation using the abovementioned alignment mark measurement results, derives the layout of all shot regions on the wafer W, and stores that layout information in the memory 65. In addition, the abovementioned detection results obtained using the focus leveling detection system 64 are stored in the memory 65. Furthermore, switching control of each valve of the liquid supply apparatus 19a and the liquid recovery apparatus 19b of the liquid immersion apparatus 17 is performed and the water Lq is supplied to the space between the front lens GL of the projection optical system PL and the wafer W (the wafer holder 40).

Next, the main control apparatus 20 reads out layout information of all shot regions from the memory 65, uses the previously obtained baseline quantity measurement results to correct the layout information, and then moves the wafer stage WST so that the shot region on the wafer W that is to be exposed first is disposed at the scanning start position. Furthermore, the main control apparatus 20 monitors the detection values of the X axis interferometer 42, the Y axis interferometer 23, and the reticle interferometer 12, and, while doing so, controls the drive of the reticle stage drive part 11 along with the first drive system 27 and the second drive systems 28a, 28b so as to scan the reticle R (the reticle stage RST) and the wafer W (the wafer stage WST) relative to the Y directions.

While they are moved uniformly during scanning (after acceleration ends and immediately prior to the start of deceleration), the pattern of the reticle R is transferred to the first shot region that is to be exposed on the wafer W by causing the reticle R (the reticle stage RST) and the wafer W (the wafer stage WST) to move in the Y directions with uniform and synchronous movement with respect to the illumination area of the illumination light IL. During the scanning of the reticle R and the wafer W, the front surface information, which was detected using the focus leveling detection system 64 prior to supplying the liquid Lq, is read out from the memory 65 and used to adjust the front surface position of the wafer W in the Z directions as well as its attitude. The abovementioned scanning is performed repetitively for all shot regions that are set on the wafer W.

When the exposure of the wafer W, which is held on the wafer stage WST, is complete, the main control apparatus 20 controls the drive of the first drive system 47 and the second drive systems 48a, 48b, which are provided to the measurement stage MST, based on the detection value of the Y axis interferometer 22 so as to bring the measurement stage MST proximate to the wafer stage WST. At this time, the main control apparatus 20 reads out the information that indicates the relative position between the wafer stage WST and the measurement stage MST (the information that is obtained by the measurements described in FIG. 5A through FIG. 7B) stored in the memory 65, and controls the drive amounts of the first drive system 27 and the second drive systems 28a, 28b, which are provided to the wafer stage WST, as well as the first drive system 47 and the second drive systems 48a, 48b, which are provided to the measurement stage MST, so that the wafer stage WST and the measurement stage MST have a prescribed positional relationship. Specifically, control is performed so that the gap G1 shown in FIG 4A is, for example, less or equal to 0.5 mm, and the gap G2 shown in FIG. 4B is, for example, less or equal to 0.1 mm.

Furthermore, the main control apparatus 20 transfers the water Lq on the wafer stage WST onto the measurement stage MST by moving both of the stages WST, MST in the +Y direction in a state wherein the abovementioned positional relationship is maintained. At this time, the abovementioned control ensures that the gap G1 between the wafer stage WST and the measurement stage MST is, for example, less or equal to 0.5 mm, which makes it possible to prevent the water Lq from leaking out of the space between the wafer stage WST (the wafer holder 40) and the measurement stage MST (the measurement table MTB). In addition, the abovementioned control ensures that the gap G2 between the wafer stage WST and the measurement stage MST is, for example, less or equal to 0.1 mm, which makes it possible to prevent the water Lq from remaining on the wafer stage WST.

Subsequently, the main control apparatus 20 controls the position of the wafer stage WST based on the detection values of the X axis interferometer 42 and the Y axis interferometer 23, and, while doing so, controls the drives of the first drive system 27 and the second drive systems 28a, 28b, which are provided to the wafer stage WST, so as to move the wafer stage WST to the prescribed loading position, and then exchanges the wafer W. Parallel therewith, prescribed measurements that use the measurement stage MST are performed as needed. These measurements include, for example, the measurement of the baseline quantity of the alignment system 45 after the reticle on the reticle stage RST has been exchanged.

When the abovementioned exchange of the wafer W on the wafer stage WST and the measurement using the measurement stage MST are complete, the main control apparatus 20 brings the wafer stage WST proximate to the measurement stage MST and once again performs the control discussed above so as to move both of the stages WST, MST in the -Y direction in a state wherein the positional relationship between the wafer stage WST and the reticle stage RST is maintained. Thereby, the water Lq on the measurement stage MST is transferred onto the wafer stage WST. At this time, the gap G1 shown in FIG. 4A is, for example, less or equal to 0.5 mm and the gap G2 shown in FIG. 4B is, for example, less or equal to 0.1 mm, which makes it possible to prevent the water Lq from leaking out of the space between the wafer stage WST (the wafer holder 40) and the measurement stage MST (the measurement table MTB), and to prevent the water Lq from remaining on the measurement stage MST.

When the transfer of the water Lq is complete, the main control apparatus 20 moves the measurement stage MST to the prescribed retraction position and returns the wafer stage WST to a position that is directly below the projection unit PU. Furthermore, on the wafer stage WST side, wafer alignment is performed on the wafer W after the exchange, i.e., the alignment system 45 detects an alignment mark on the exchanged wafer W and performs EGA calculations in order to derive the positional coordinates of the multiple shot regions on the wafer W. Subsequently, the main control apparatus 20 performs a step-and-scan system exposure operation on the new wafer W, similar to that described above, and successively transfers the reticle pattern to the multiple shot regions on the wafer.

Furthermore, in the previously discussed measurement wherein the alignment system 45 is used to measure the relative position between the wafer stage WST and the measurement stage MST in the Y directions, the alignment system 45 sequentially measures two locations (the measurement points P11, P12) of the edge part e1 of the measurement stage MST (the measurement table MTB) and two locations (the measurement points P21, P22) of the edge part e2 of the wafer stage WST (the wafer holder 40) as was explained using FIG. 5A through FIG. 6B. Alternatively, if the size of the measurement field of the alignment system 45 in the Y directions is approximately 1 mm or greater, then it is preferable to bring the measurement stage MST and the wafer stage WST proximate to one another, to dispose both the edge part e1 and the edge part e2 in the measurement field of the alignment system 45, and to perform the measurements simultaneously. Performing the measurements in this manner makes it possible to reduce the amount of time needed for the measurements.

In addition, in the embodiment explained above, the alignment system 45 measures the relative position between the wafer stage WST and the measurement stage MST in the Y directions, and the focus leveling detection system 64 measures the relative position between the wafer stage WST and the measurement stage MST in the Z directions. Alternatively, it is possible not only to measure the position information of the marks in the XY plane, but also to use an alignment system than can detect the focus state to measure the relative position between the wafer stage WST and the measurement stage MST in the Y directions and the Z directions simultaneously.

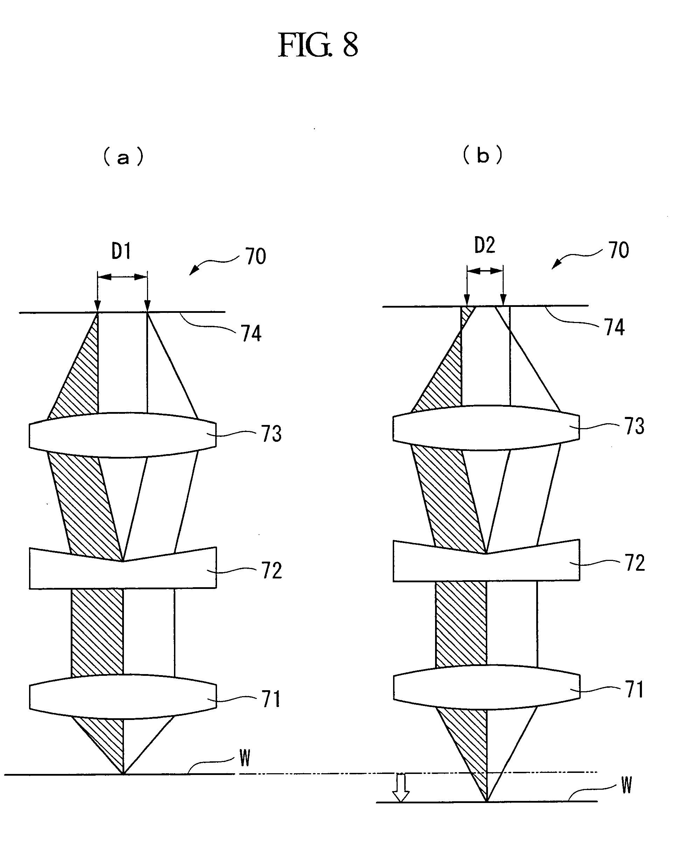

FIG. 8 is a view for explaining the principle of detection of a focus state detection system, which is provided to the alignment system. As shown in FIG. 8, a focus state detection system 70 comprises an objective 71, a pupil dividing mirror 72, a condenser lens 73, and an imaging device 74, such as a CCD. Furthermore, the objective 71 of the optical members shown in FIG. 8 preferably also serves as the objective that is provided to the alignment system that measures the position information of the marks. The reflected light image from the front surface of the wafer W impinges the pupil dividing mirror 72 via the objective 71, which causes loss of telecentricity. The reflected light image for which there is a loss of telecentricity is condensed by the condenser lens 73 and then imaged in an imaging plane of the imaging device 74.

Namely, the focus state detection system 70 detects the amount of deviation between the imaging plane position of the imaging device 74 and the imaging position of the reflected light image from the front surface of the wafer W in the focus directions as a change in the spacing between the images that are imaged at different positions in the imaging plane of the imaging device 74 (the images resulting from the division by the pupil dividing mirror 72). Here, as shown in part (a) of FIG. 8, when the amount of defocus is zero, the spacing between the images is assigned to D 1.

As shown in part (b) of FIG. 8, if the wafer W is defocused in the -Z direction from the state shown in part (a) of FIG. 8, then the spacing between the images resulting from the division by the pupil dividing mirror 72 is assigned to D2, which is narrower than the spacing D1. In contrast, if the wafer W is defocused in the +Z direction, then the spacing between the images resulting from the division by the pupil dividing mirror 72 becomes a spacing that is wider than the spacing D1. Accordingly, measuring the spacing between the images in the imaging plane of the imaging device 74 makes it possible to measure the amount of defocus. Providing the focus state detection system to the alignment system as explained above makes it possible to measure the relative positions between the wafer stage WST and the measurement stage MST in the Y directions and the Z directions simultaneously. As a result, it is possible to reduce the time that is needed to measure the relative positions.

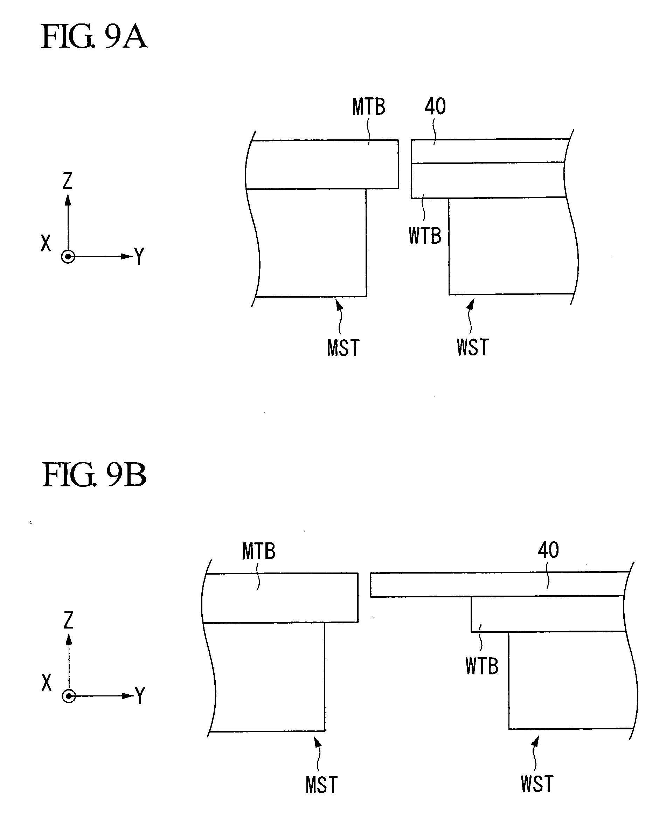

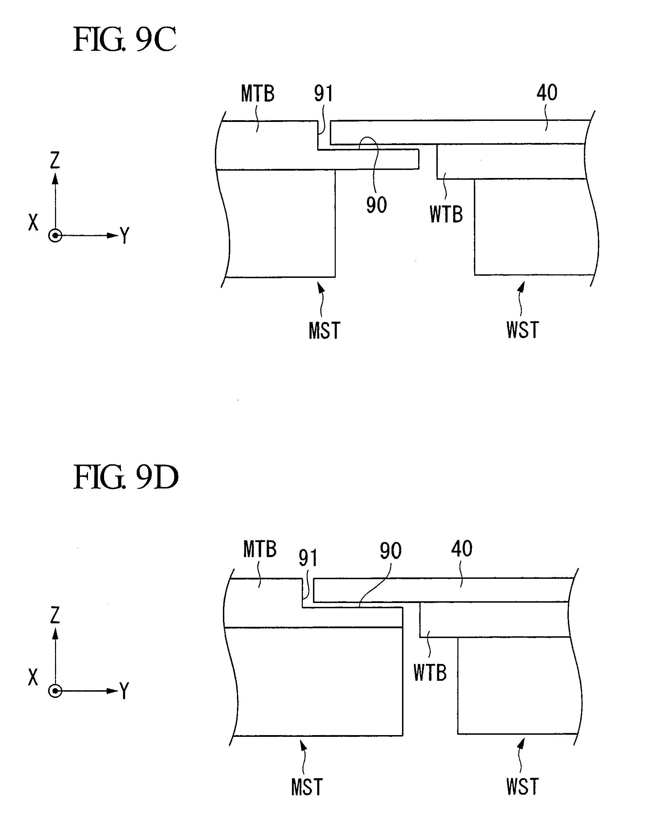

FIGS. 9A, 9B, 9C, and 9D are enlarged views of the edge parts of the wafer stage WST and the measurement stage MST when they are in a proximate state. The above explained an exemplary case wherein the end parts of the wafer table WTB of the wafer stage and the wafer holder 40 in the -Y direction are lined up as shown in FIG. 9A. Alternatively, as shown in FIG. 9B, the wafer holder 40 may project beyond the wafer table WTB in the -Y direction on the -Y direction side of the wafer stage WST.

In addition, as shown in FIG. 9C, the wafer holder 40 of the wafer stage WST may be in a state wherein it projects beyond the wafer table WTB in the -Y direction, and the measurement stage MST may be configured so that a stepped part 90 is formed along an edge of the measurement table MTB on the +Y direction side. With this configuration, when the wafer stage WST and the measurement stage MST are proximate to one another, a state arises wherein the wafer holder 40 that projects toward the -Y side covers the upper part (in the +Z direction) of the stepped part 90 of the measurement table MTB. Furthermore, as shown in FIG. 9D, a configuration is also acceptable in which the measurement table MTB, wherein the stepped part 90 is formed, does not project in the +Y direction.

With the configurations shown in FIG. 9C and FIG. 9D, a stepped part 91 shown in the figures is the edge part e1 of the measurement table MTB on the +Y direction side (refer to FIG. 5A and FIG. 6A). Accordingly, the alignment system 45 is used to measure the stepped part 91 when the relative position between the wafer stage WST and the measurement stage MST in the Y directions is measured. In addition, control is performed so that the spacing (the gap) between the stepped part 91 and the wafer holder 40 is less or equal to 0.5 mm when the wafer stage WST and the measurement stage MST are brought proximate to one another.

The above explained the embodiments of the present invention, but the specific constitution is not limited to these embodiments, and it is understood that variations and modifications may be effected without departing from the spirit and scope of the invention. For example, in the embodiment discussed above, the alignment system 45, which is provided in order to measure the alignment marks on the wafer W, and the focus leveling detection system 64, which is provided in order to detect the front surface position of the wafer W in the Z directions and its attitude, are used to measure the relative position between the wafer stage WST and the measurement stage MST. Alternatively, specialized measuring apparatuses for measuring these relative positions may be provided and used in these measurements.

For example, the relative position in the Y directions may be measured by providing a measuring apparatus to either the wafer stage WST or the measurement stage MST, and then measuring the distance to the other stage. When performing such a measurement, a configuration is preferable wherein the distance between the edge parts e1, e2 (refer to FIG. 5A and FIG. 6A) can be measured directly. In addition, if a fiducial member that indicates the reference position of the relevant stage is provided to a side surface of the other stage (the side surface on the -Y side in the case of the wafer stage WST, and the side surface on the +Y side in the case of the measurement stage MST), then the deviation in the Z directional position may be measured by measuring this fiducial member.

In addition, the abovementioned embodiment explained an exemplary case wherein ArF excimer laser light is used, but it is also possible to use, for example, g line light (436 nm wavelength), i line light (365 nm wavelength), KrF excimer laser light (248 nm wavelength), F₂ laser light (157 nm wavelength), Kr₂ laser light (146 nm wavelength), YAG laser light, or the high frequency light of a semiconductor laser. Furthermore, higher harmonics may also be used by using, for example, an erbium (or erbium-ytterbium) doped fiber amplifier to amplify single wavelength laser light in the infrared region or the visible region that is oscillated from a DFB semiconductor laser or a fiber laser, and then using a nonlinear optical crystal to perform wavelength conversion so as to convert the output laser light to ultraviolet light. For example, if the oscillating wavelength of the single wavelength laser is in the range of 1.51 to 1.59 µm, then the eighth harmonic, wherein the generating wavelength is in the range of 189 to 199 nm, or the tenth harmonic, wherein the generating wavelength is in the range of 151 to 159 nm, is output.

Furthermore, in each of the abovementioned embodiments, the position information of the reticle stage RST and the wafer stage WST is measured using the interferometer system (24), but the present invention is not limited thereto and, for example, an encoder system may be used that detects a scale (diffraction grating) that is provided to each stage. In this case, the system is configured as a hybrid system that is provided with both an interferometer system and an encoder system, and it is preferable to use the measurement results of the interferometer system to calibrate the measurement results of the encoder system. In addition, the positions of the stages may be controlled by switching between the interferometer system and the encoder system, or by using both.

In addition, the present invention can also be adapted to a twin stage type exposure apparatus, which is provided with a plurality of wafer stages. The structure and exposure operation of a twin stage type exposure apparatus is disclosed in, for example, Japanese Patent Application, Publication No. H10-163099 A, Japanese Patent Application, Publication No. H10-214783 A (corresponding U.S. Patent Nos. 6,341,007, 6,400,441, 6,549,269 and 6,590,634), Published Japanese Translation No. 2000-505958 of the PCT International Publication (corresponding U.S. Patent No. 5,969,441), or U.S. Patent No. 6,208,407. In this case, the gaps G1, G2 between multiple wafer stages may be controlled instead of the measurement stage MST, and the water Lq may be transferred between the multiple wafer stages. Furthermore, the gaps G1, G2 between the wafer stage WST and a stage that does not have a measuring function may be controlled, and the water Lq transferred therebetween. Furthermore, the present invention may be adapted to the wafer stage disclosed in Japanese Patent Application No. 2004-168481 (corresponding PCT International Publication No. WO 2005/122242), which was previously filed by the present applicant.

In addition, the projection optical system PL may be telecentric on both the object plane (the reticle R) side and the image plane (the wafer W) side, or it may be telecentric on just one side. Furthermore, a unity magnification image of the pattern image of a mask M may be projected in addition to a reduced image thereof that is projected by a reduction system. Furthermore, a catoptric system, which comprises only catoptric elements, or a catadioptric system, which comprises catoptric elements and dioptric elements, may be used as the projection optical system PL. Furthermore, in accordance with the wavelength of the illumination light IL, quartz, fluorite, or the like may be used as the glass material of the multiple lens elements that constitute the projection optical system PL.

Furthermore, the substrate held by the movable stage in each of the abovementioned embodiments is not limited to a semiconductor wafer for fabricating semiconductor devices, but can also be adapted to, for example, a glass substrate for a display device, a ceramic wafer for a thin film magnetic head, or the original plate (synthetic quartz or a silicon wafer) of a mask or a reticle that is used in an exposure apparatus. The exposure apparatus EX can also be adapted to a scanning type exposure apparatus that does not use the liquid immersion method, as well as to a step-and-repeat type projection exposure apparatus (stepper) that exposes the full field of the pattern of the reticle R with the reticle R and the wafer W in a stationary state, and sequentially steps the wafer W. In addition, the present invention can also be adapted to a step-and-stitch system exposure apparatus that partially and superimposingly transfers at least two patterns onto the wafer W. The type of exposure apparatus EX is not limited to a semiconductor device fabrication exposure apparatus that exposes the pattern of a semiconductor device on the wafer W, but can also be widely adapted to an exposure apparatus that is used for fabricating, for example, liquid crystal devices or displays, and an exposure apparatus that is used for fabricating thin film magnetic heads, imaging devices (CCDs), micromachines, MEMS, DNA chips, or reticles and masks.

In addition, each of the abovementioned embodiments was explained by taking as an example an exposure apparatus that is provided with the projection optical system PL, but the present invention can be adapted to an exposure apparatus and an exposure method that do not use the projection optical system PL. Even if a projection optical system is not used, exposure light is radiated onto the substrate through optical members, such as a mask or a lens, and an immersion region is formed in a prescribed space between the substrate and such optical members.

Furthermore, in the embodiments discussed above, a light transmitting type mask is used wherein a prescribed shielding pattern (or a phase pattern or a dimming pattern) is formed on a light transmitting substrate; however, instead of such a mask, it is also possible to use an electronic mask wherein a transmittance pattern, a reflected pattern, or a light emitting pattern is formed based on electronic data of the pattern to be exposed, as disclosed in, for example, U.S. Patent No. 6,778,257; here, electronic masks, which are also called variable forming masks, include, for example, a digital micromirror device (DMD), which is one type of a non light emitting image display device (spatial light modulator).

Furthermore, the present invention can also be adapted to an exposure apparatus that combines, through a projection optical system, the patterns of two masks on a substrate, and double exposes, substantially simultaneously, a single shot region on the substrate with a single scanning exposure, as disclosed in, for example, Published Japanese Translation No. 2004-519850 of the PCT International Publication (corresponding U.S. Patent No. 6,611,316).

If a linear motor is used in the wafer stage WST or the reticle stage RST (refer to U.S. Patent No. 5,623,853 and U.S. Patent No. 5,528,118), then either an air levitation type that uses an air bearing, or a magnetic levitation type that uses Lorentz's force or reactance force may be used. In addition, each of the stages WST, RST may be a type that moves along a guide or may be a guideless type. A planar motor may be used for the drive mechanism of each of the stages WST, RST; in each stage, the planar motor causes a magnet unit, wherein magnets are disposed two dimensionally, and an armature unit, wherein coils are disposed two dimensionally, to oppose one another, and drives each the stage using electromagnetic force. In this case, for each of the stages WST, RST, either the magnet unit or the armature unit should be connected to the stage, and the other unit should be provided on the moving surface side of the stage.

The reaction force generated by the movement of the wafer stage WST may be mechanically discharged to the floor (ground) by using a frame member so that it is not transmitted to the projection optical system PL, as recited in Japanese Patent Application, Publication No. H08-166475 A (U.S. Patent No. 5,528,118). The reaction force generated by the movement of the reticle stage RST may be mechanically discharged to the floor (ground) by using a frame member so that it is not transmitted to the projection optical system, as recited in Japanese Patent Application, Publication No. H08-330224 (corresponding U.S. Patent No. 5,874,820).

As far as is permitted, the disclosures in all of the Publications and U.S. Patents related to exposure apparatuses and the like cited in the above respective embodiments and modified examples, are incorporated herein by reference.

As described above, the exposure apparatus EX of the embodiments in the present application is manufactured by assembling various subsystems, including each constituent element, so that prescribed mechanical, electrical, and optical accuracies are maintained. To ensure these various accuracies, adjustments are performed before and after this assembly, including an adjustment to achieve optical accuracy for the various optical systems, an adjustment to achieve mechanical accuracy for the various mechanical systems, and an adjustment to achieve electrical accuracy for the various electrical systems. The process of assembling the exposure apparatus from the various subsystems includes interconnecting the various subsystems, e.g., interconnecting mechanical components, electrical circuits, and atmospheric pressure circuit pipes. Naturally, the processes of assembling each individual subsystem are performed before the process of assembling the exposure apparatus from these various subsystems is performed. When the process of assembling the exposure apparatus from the various subsystems is complete, a comprehensive adjustment is performed to ensure the various accuracies of the exposure apparatus as a whole. Furthermore, it is preferable to manufacture the exposure apparatus in a clean room, wherein the temperature, the cleanliness level, and the like are controlled.

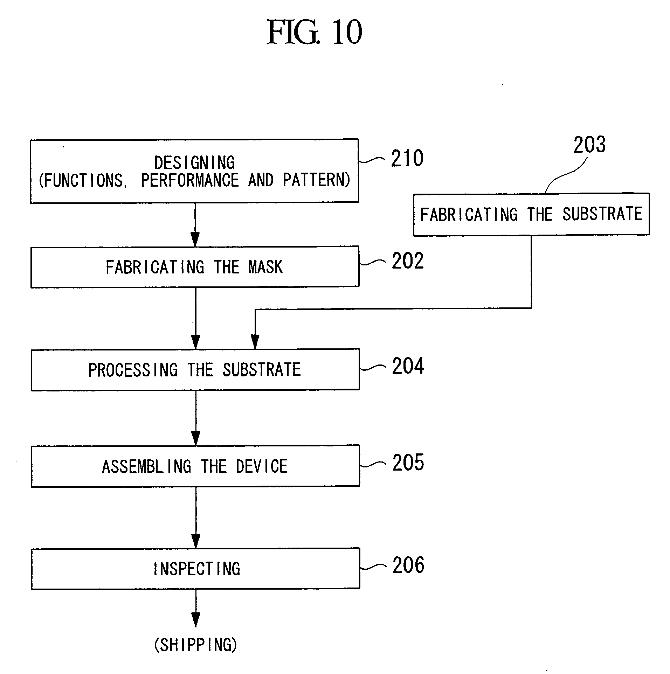

FIG. 10 is a flow chart that shows one example of a process of fabricating a microdevice (e.g., a semiconductor chip like an IC or an LSI, a liquid crystal panel, a CCD, a thin film magnetic head, or a micromachine). As shown in FIG. 10, a microdevice, such as a semiconductor device, is fabricated by, for example: a step S210 that designs the functions and performance of the microdevice; a step S202 that fabricates a mask (reticle) based on this design step; a step S203 that fabricates a substrate (a wafer), which is the base material of the device; a step S204 that includes substrate treatment processes such as the process of transferring the pattern of the mask onto the substrate using the exposure apparatus EX of the embodiments discussed above, a process that develops the exposed substrate, and a process that heats (cures) and etches the developed substrate; a device assembling step S205 (comprising fabrication processes such as a dicing, bonding, and packaging); and an inspecting step S206.

## Claims

1. A stage apparatus, comprising:
first and second stages that move along a base surface;
a first measurement apparatus that measures a first gap between the first and second stages along a first direction that intersects the base surface; and
a first adjustment apparatus that adjusts the first gap based on a measurement result of the first measurement apparatus.

2. A stage apparatus according to Claim 1, wherein
the first adjustment apparatus adjusts the position of at least one stage of the first and second stages in the first direction when the first and second stages are proximate to one another.

3. A stage apparatus according to Claim 1 or Claim 2, wherein
the first adjustment apparatus adjusts the position of at least one stage of the first and second stages in the first direction so that the first gap is less or equal to 0.1 mm.

4. A stage apparatus according to any one of Claims 1 to 3, wherein
the first direction is orthogonal to the base surface.

5. A stage apparatus according to any one of Claims 1 to 4, further comprising:
a second measurement apparatus that measures a second gap between the first and second stages along the base surface; and
a second adjustment apparatus that adjusts the second gap based on a measurement result of the second measurement apparatus.

6. A stage apparatus according to Claim 5, wherein
the second adjustment apparatus adjusts the position of at least one stage of the first and second stages along the base surface so that the second gap is less or equal to 0.5 mm.

7. A stage apparatus, comprising:
first and second stages that move along a base surface;
a measuring apparatus that measures the positions of the first and second stages along the base surface;
a detection apparatus that detects an edge of an upper surface of the first stage and an edge of an upper surface of the second stage; and
an adjustment apparatus that adjusts the position of at least one stage of the first and second stages along the base surface based on a measurement result of the measuring apparatus and a detection result of the detection apparatus.

8. A stage apparatus according to Claim 7, wherein
the adjustment apparatus adjusts the position of at least one stage of the first and second stages along the base surface so that a first gap between the first and second stages along the base surface is less or equal to 0.5 mm.

9. A stage apparatus according to Claim 7 or Claim 8, further comprising:
a calculation apparatus that derives, based on the detection result of the detection apparatus, a second gap between the first and second stages along a direction that intersects the base surface.

10. A stage apparatus according to any one of Claims 1 to 9, wherein
part of the first stage or part of the second stage projects toward the other stage.

11. An exposure apparatus that exposes a substrate through a liquid, comprising:
a stage apparatus according to any one of Claims 1 to 6,
wherein the first measurement apparatus measures the first gap without transiting through the liquid.

12. An exposure apparatus that exposes a substrate through a liquid, comprising:
a stage apparatus according to any one of Claims 7 to 10;
wherein the detection apparatus detects an edge of an upper surface of the first stage and detects an edge of the upper surface of the second stage without transiting through the liquid.

13. An exposure apparatus according to Claim 11 or Claim 12, wherein
the first stage is a substrate stage that holds the substrate; and the second stage is a measurement stage that measures information related to the exposure.

14. A device fabricating method that comprises an exposure process, wherein
an exposure apparatus according to any one of Claims 11 to 13 is used.

15. A method of moving an immersion area between a first member and a second member, which are capable of relative movement, in order to perform an immersion exposure, comprising:
a first step that moves a liquid between the first member and the second member; and
a second step that, prior to the first step, measures a positional relationship between the first member and the second member.

16. A method according to Claim 15, further comprising:
a third step that, between the first step and the second step, adjusts the positional relationship between the first member and the second member based on the measurement that was performed in the second step.

17. An exposing method that exposes a substrate, which is held by a first member, through a liquid, comprising:
a first step that moves a liquid between the first member and a second member, which is capable of moving relative to the first member; and
a second step that, prior to the first step, measures a positional relationship between the first member and the second member.

18. An exposing method according to Claim 17, further comprising:
a third step that, between the first step and the second step, adjusts the positional relationship between the first member and the second member based on the measurement that was performed in the second step.

19. An exposing method according to Claim 18, wherein
the first and second members are capable of moving along a base surface;
in the second step, a first gap between the first and second members is measured in a first direction that intersects the base surface; and
in the third step, the first gap is adjusted based on the measurement.

20. An exposing method according to Claim 19, wherein
in the third step, the position of at least one member of the first and second members in the first direction is adjusted so that the first gap is less or equal to 0.1 mm.

21. An exposing method according to Claim 19, wherein
an exposure is performed by filling a space between an optical member and the first member with the liquid; and
the first direction is a direction in an optical axis direction of the optical member.

22. An exposing method according to Claim 18, wherein
the first and second members are capable of moving along a base surface;
in the second step, a second gap between the first and second members is measured along the base surface; and
in the third step, the second gap is adjusted based on the measurement.

23. An exposing method according to Claim 22, wherein
in the third step, the position of at least one member of the first and second members along the base surface is adjusted so that the second gap is less or equal to 0.5 mm.

24. An exposing method according to Claim 18, wherein
the first and second members are capable of moving along a base surface;
the second step comprises:
a fourth step that measures the position of each of the first and second members along the base surface; and
a fifth step that detects an edge of an upper surface of the first member and an edge of an upper surface of the second member; and
the third step adjusts the position of at least one member of the first and second members along the base surface based on the fourth step and the fifth step.

25. An exposing method according to Claim 17, wherein
in the second step, the positional relationship between the first member and the second member is measured without transiting through the liquid.

26. A device fabricating method that comprises an exposure process, wherein
an exposing method according to any one of Claims 15 to 25 is used.

27. An exposing method that is a method of fabricating an exposure apparatus that exposes a substrate through a liquid, comprising:
a step that supplies a stage apparatus according to any one of Claims 1 to 10; and
a step that measures a positional relationship between the first stage and the second stage without transiting through the liquid.
